# EUROPEAN PATENT APPLICATION

(11) **EP 4 734 372 A1**
(43) Date of publication of application: **29.04.2026**
(21) Application number: 24306777.4
(22) Date of filing: 22.10.2024
(51) Int. Cl.: H03K 17/16, H02M 1/00

(54) **A VOLTAGE GATE DRIVER**

(71) Applicant: NXP USA, Inc., Austin TX 78735 (US)
(72) Inventor: ATTANASIO, Marco, 5656 AG Eindhoven (NL); LILIC, Nenad, 5656 AG Eindhoven (NL); RHINOW, Christoph, 5656 AG Eindhoven (NL); RYABCHENKOV, Sergey Sergeevich, 31023 cedex 1 Toulouse (FR); KANDAH, Ibrahim Shihadeh, 5656 AG Eindhoven (NL)
(74) Representative: Schmütz, Christian Klaus Johannes

(57) **Abstract**

A voltage gate driver (400) comprising:
an OpAmp (401);
a current source (402);
a pull switch (403) configured to switchably operate in one of: a disconnected mode; and a pull mode,
wherein one or both of:
a) the operational amplifier (401) is configured to switchably operate in one of:
a regulation mode;
a pull mode, wherein the operational amplifier operates in the pull mode when the pull switch operates in the pull mode; and
a disconnected mode in which the output node is disconnected from the operational amplifier and the reference voltage node; and
b) the current source (402) is configured to switchably operate in one of:
a controlled shutdown mode;
a pull mode, wherein the current source operates in the pull mode when the pull switch operates in the pull mode; and
a disconnected mode in which the output node is disconnected from the current source and the reference voltage node.

## Description

### Field

The present disclosure relates to: a voltage gate driver configured to provide a voltage to an output node for receipt by a gate of a power switch; and a power device comprising a voltage gate driver of the present disclosure and a power switch configured to be driven by the volage gate driver.

### Summary

According to a first aspect of the present disclosure, there is provided a voltage gate driver configured to provide a voltage at an output node for receipt by a gate of a power switch, the voltage gate driver comprising: an operational amplifier comprising a first transistor; a current source comprising a second transistor; a pull switch comprising a third transistor wherein the pull switch is configured to switchably operate in one of: a disconnected mode in which the output node is disconnected from a reference voltage node; and a pull mode configured to couple the output node to the reference voltage node via the third transistor such that the voltage at the output node is set to the reference voltage, wherein one or both of: a) the operational amplifier comprises a first switching network configured to control a mode of operation of the operational amplifier, wherein the operational amplifier is configured to switchably operate in one of: a regulation mode configured to cause the first transistor to provide an intermediate voltage at the output node for driving the gate of the power switch; a pull mode configured to couple the output node to the reference voltage node via the first transistor such that the voltage at the output node is set to the reference voltage and wherein the operational amplifier operates in the pull mode when the pull switch operates in the pull mode; a disconnected mode in which the output node is disconnected from the operational amplifier and the reference voltage node; and b) the current source comprises a second switching network configured to control a mode of operation of the current source, wherein the current source is configured to switchably operate in one of: a controlled shutdown mode in which the second transistor provides a voltage at the output node for controlled shutdown of the power switch; a pull mode configured to couple the output node to the reference voltage node via the second transistor such that the voltage at the output node is set to the reference voltage and wherein the current source operates in the pull mode when the pull switch operates in the pull mode; a disconnected mode in which the output node is disconnected from the current source and the reference voltage node.

In one or more embodiments, the first switching network may comprises: a first OpAmp switch configured to selectively couple the first transistor to the rest of the operational amplifier such that, the operational amplifier is configured to operate in the regulation mode when the first transistor is coupled to the rest of the operational amplifier; a second OpAmp switch and a third OpAmp switch of a first tri-state driver wherein the second and third OpAmp switches are configured to provide a first control voltage to a first control terminal of the first transistor when the first transistor is disconnected from the rest of the operational amplifier in order to cause the operational amplifier to selectively operate in one of the pull mode and the disconnected mode.

In one or more embodiments, wherein the second switching network may comprise: a first PCS switch configured to selectively couple the second transistor to the rest of the current source such that, the current source is configured to operate in the controlled shutdown mode when the second transistor is coupled to the rest of the current source; a second PCS switch and a third PCS switch of a second tri-state driver wherein the second and third PCS switches are configured to provide a second control voltage to a second control terminal of the second transistor when the second transistor is disconnected from the rest of the current source in order to cause the current source to selectively operate in one of the pull mode and the disconnected mode.

In one or more embodiments, wherein the voltage gate driver may comprise a mode controller configured to control the mode of the operational amplifier, the current source and the pull switch.

In one or more embodiments, only one of the regulation mode, the controlled shutdown mode and the pull mode may be active at any time.

In one or more embodiments, when the operational amplifier is operating in the regulation mode, the current source and the pull switch may be configured to operate in the disconnected mode; when the current source is operating in the controlled shutdown mode, the operational amplifier and the pull switch may be configured to operate in the disconnected mode; and when the pull switch is operating in the pull mode, one or both of the operational amplifier and the current source may be configured to operate in their respective pull modes.

In one or more embodiments, the current source may be a programmable current source.

According to a second aspect of the present disclosure, there is provided a power device comprising a power switch and a voltage gate driver of the first aspect configured to drive the power switch.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of a voltage gate driver according to the present disclosure;
Figure 2 shows an example embodiment of an output stage of an operational amplifier comprising a switching network of the present disclosure;
Figures 3A - 3C show a series of example embodiments of the output stage of an operational amplifier comprising a switching network operating in different modes according to the present disclosure;
Figure 4 shows a further example embodiment of a voltage gate driver according to the present disclosure; and
Figure 5 shows an example representation of a chip surface of a power device comprising a voltage gate driver of the present disclosure.

### Detailed Description

A voltage gate driver is a type of power amplifier that takes a low-voltage, high-impedance input from a controller (like a microcontroller or processor) and produces a high-voltage, low-impedance drive signal. This signal is used to control the gate of a high-power power switch, such as an IGBT (Insulated Gate Bipolar Transistor) or a power MOSFET (Metal-Oxide-Semiconductor Field-Effect Transistor).

Gate drivers are essential in applications requiring fast switching times, such as in power electronic converters, because they ensure the transistor switches on and off quickly and efficiently. It is also desirable to be able to provide for controlled shutdown of a power switch by way of a current source steadily pulls the voltage at the driven gate to a reference voltage such as ground.

Low-ohmic output stage devices of the components of a voltage gate driver have significant die area on a chip, especially in high current, high-voltage applications. Several blocks such as low-ohmic switches, operational amplifier and current sources may drive the same pins of different modes. The present disclosure provides a voltage gate driver that allows for a reduction in the total area of power stage devices by sharing some of the same output stage transistors for different functions. By reducing the total area taken by these blocks, may allow for improved layout routing, as the blocks can be more located in immediate proximity to the bond pads, thereby facilitating the routing while saving yet further surface area.

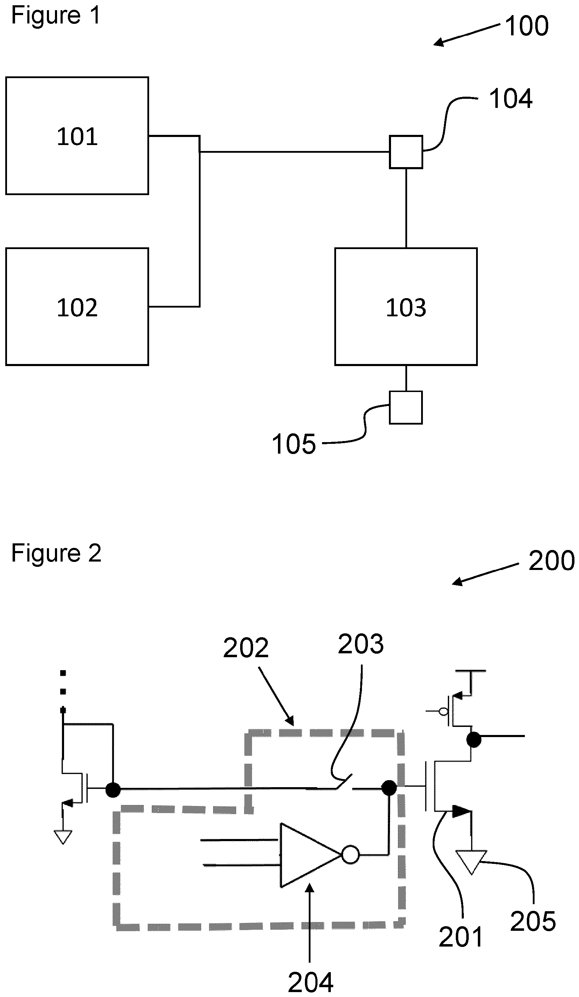

Figure 1 shows an example voltage gate driver 100 according to the present disclosure. The voltage gate driver comprises at least three blocks: an operational amplifier 101, a current source 102 and a pull switch 103. Each block is coupled to a same output node 104 of the voltage gate driver 100. The output node 104 of the voltage gate driver 100 is configured to be coupled to a power switch (not shown) and, in particular, may be coupled to a gate terminal of a power switch such that a voltage provided at the output node 104 is provided, in use, to the gate terminal of the power switch. The power switch may be any suitable power switch which needs to be driven by a voltage gate driver 100 such as, by way of non-exhaustive examples, an IGBT (Insulated Gate Bipolar Transistor) or a power MOSFET (Metal-Oxide-Semiconductor Field-Effect Transistor).

An operational amplifier 101 in a voltage gate driver 100 may typically be used to provide for a regulation mode in which an intermediate voltage is provided at the output node 104 of the voltage gate driver 100. The intermediate voltage may be set to be, in use, between a first reference voltage and a second reference voltage. For example, the first reference voltage may be a source voltage, which may be a positive or a negative voltage rail. The second reference voltage may be, for example, a ground voltage. It will be appreciated that all voltages are relative potential differences and so the relative voltages are what should be considered. Thus, the intermediate voltage may have a voltage between the first reference voltage and the second reference voltage of the voltage gate driver 100. Providing the intermediate voltage to the output node 104 may allow the gate of the power switch to be driven at an intermediate level which provides for tuned operation of the power switch. This may be beneficial for wave shaping applications or in the case of short circuits.

The operational amplifier 101 is comprised of a plurality of individual components. The exact structure of the operational amplifier 101 is not of importance in the present disclosure. That is, the operational amplifier 101 may have any appropriate structure to allow it to provide the described functionality. The operational amplifier 101 does have, as part of its output stage, a first transistor (not shown in figure 1) which is configured to provide an output voltage to the output node 104 of the voltage gate driver 100 when the operational amplifier 101 is operating in the regulation mode.

A current source 102 in a voltage gate driver 100 may be used to provide for a soft shutdown mode. A soft shutdown mode provides for safe turn off of a power device in the event of a fault condition, such as overcurrent or desaturation. More generally, the current source 102 may be configured to pull the voltage at the output node 104 of the voltage gate driver 100 to a reference voltage. The current source 102 may pull the voltage at the output node 104 to the reference voltage in a controlled and slow manner. In a soft shutdown mode, the gate voltage provided at the output node 104 of the voltage gate driver 100 is steadily reduced. By operating in a soft shutdown mode, high voltage spikes that would otherwise be caused by abrupt cutting off of the gate voltage can be avoided. Soft shutdown modes may also be beneficial in other fault conditions.

In one or more embodiments, the programmable current source. The programmable current source (or non-programmable current source) 102 may be comprised of a plurality of individual components. The exact structure of the current source 102 is not of importance in the present disclosure. That is, the current source 102 may have any appropriate structure to allow it to provide the described functionality. The current source 102 does have, as part of its output stage, a second transistor (not shown in figure 1) which is configured to provide an output voltage to the output node 104 of the voltage gate driver 100 when the current source 102 is configured to provide an output. It will be appreciated that the phrase "second transistor" is used here to differentiate the output transistor of the current source from other transistors described herein and is not intended to imply a particular order of position or importance relative to any other transistors of the disclosure.

A pull switch 103 in a voltage gate driver may be used to pull the voltage at the output node 104 of the voltage gate driver 100 to a reference voltage 105 when operating in a pull mode. In contrast to the current source 102, the pull switch 103 may be configured to pull the voltage at the output node 104 to the reference voltage 105 quickly or immediately. That is, the pull switch 103, when operating in a pull mode, may pull the voltage at the output node to the reference voltage quicker than the current source 102 pulls the voltage at the output node 104 to the reference voltage 105. The pull switch 103 may be a low ohmic switch or may have a different structure.

The pull switch 103 may comprise a plurality of individual components or only a single third transistor. The exact structure of the pull switch 103 is not of importance in the present disclosure. That is, the pull switch 103 may have any appropriate structure to allow it to provide the described functionality. The pull switch 103 does have, as part of its output stage, a third transistor (not shown in figure 1) which is configured to pull a voltage at the output node 104 of the voltage gate driver 100 to a reference voltage when operating in the pull mode. It will be appreciated that the phrase "third transistor" is used here to differentiate the output transistor of the pull switch 103 from other transistors described herein and is not intended to imply a particular order of position or importance relative to any other transistors of the disclosure.

In particular, the pull switch 103 may be configured to switchably operate in one or two different modes. A first mode may be a disconnected mode in which the output node 104 of the voltage gate driver is disconnected from the reference voltage node 105 which, in use provides a reference voltage. Thus, in the disconnected mode, the pull switch 103 does not actively contribute to the voltage at the output node 104. A second mode of operation of the pull switch 103 may be the pull mode in which the pull switch 103 is configured to couple the output node of the voltage gate driver 100 to the reference voltage node 105 such that, in use, the voltage at the output node 104 is set to the reference voltage.

It will be appreciated that the reference voltage in the context of the present disclosure may be a positive reference voltage, a negative reference voltage or a relative ground voltage. In particular, the voltage gate driver of the present disclosure may be configured to provide a voltage to a gate low (GL) gate driver node. In such embodiments, the reference voltage may be a reference voltage such a relative ground reference voltage. In other examples, the voltage gate driver of the present disclosure may be configured to provide a voltage to a gate high (GH) gate driver node. In such embodiments, the reference voltage may be a relative positive voltage such as a supply voltage level. It will be appreciated that the voltage gate driver according to the present disclosure may be applied to a plurality of different gate driver output nodes configured to drive the gate of a power switch.

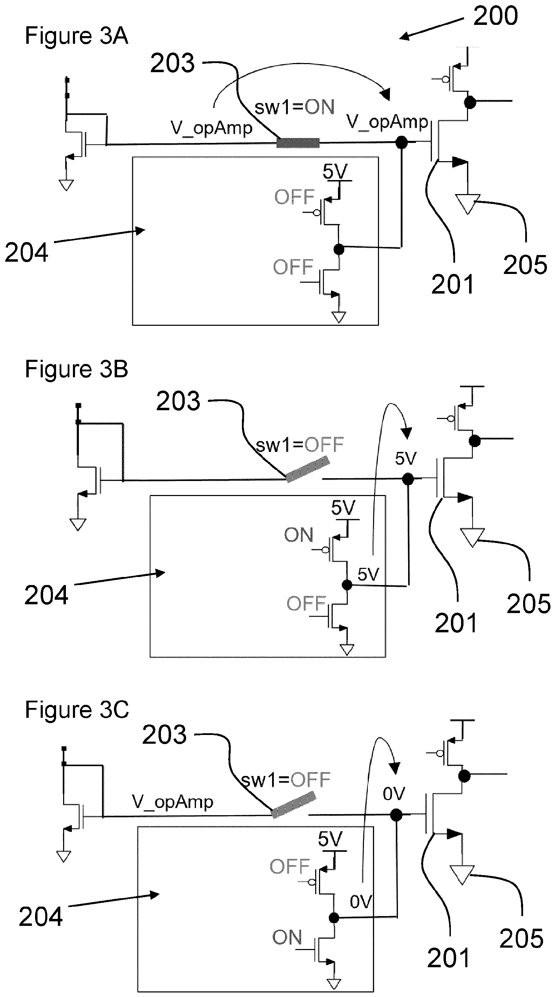

Figure 2 shows an example output stage 200 of an operational amplifier 101 according to the present disclosure which may be part of the operational amplifier 101 of the voltage gate driver 100. The control terminal (gate or base) of the first output transistor 201 of the output stage 200 is coupled to the remainder of the operational amplifier via a switching network 202. The switching network 202 is able to switchably control a mode of operation of the first output transistor 201 by controlling a voltage provided to the control terminal of the first transistor 201 by either connecting its gate node to the remaining part of the operational amplifier 101, or controlling it with the tri-state driver 204. The switching network 202 comprises a first operational amplifier (OpAmp) switch 203 coupled between the remainder of the operational amplifier and the and the first transistor 201. The first OpAmp switch 203 may be configured to selectively couple the first transistor 201 to the rest of the operational amplifier such that the operational amplifier 101 is configured to operate in the regulation mode when the OpAmp switch 203 is closed to couple the first transistor 201 to the rest of the operational amplifier. The switching network 202 further comprises a tri-state driver 204 which provides further control of the modes of operation of the first transistor 201, as described further with reference to figures 3A - 3C. The tri-state driver 204 may comprise a Op Amp second and third Op Amp switch and it may be configured to be activated, i.e., contribute a voltage to the control terminal of the first transistor 201, if the first OpAmp switch 203 is open. It will be appreciated that the terms "OpAmp switch" are used herein as nomenclature to denote that these switches are part of the operational amplifier 101 and not to ascribe any meaning to their structure.

Figure 3A shows an example of the output stage 200 of the operational amplifier 101 when operating in the regulation mode. When operating in the regulation mode, the OpAmp voltage, V_opAmp, is provided at the control terminal of the first transistor 201 such that the coupled power switch is driven by an intermediate voltage. To operate in the regulation mode, the first OpAmp switch 203 is closed to provide for the coupling of the first transistor 201 to the rest of the operational amplifier 101. While operating in the regulation mode, the second and third OpAmp switches of the tri-state driver 204 are turned off (open) such that they do not contribute a voltage to the control terminal of the first transistor 201.

Figure 3B shows an example of the output stage 200 of the operational amplifier 101 when operating in a pull mode. When the operational amplifier 101 is operating in the pull mode, the output node 104 of the voltage gate driver 100 may be coupled to the reference voltage node 205 such that the output node is set to the reference voltage, when in use. The operational amplifier 101 may be configured to operate in the pull mode when the pull switch 103 is operating in the pull mode of the pull switch 103. By allowing both the operational amplifier 101 and the pull switch 103 to simultaneously operate in a pull mode using the same reference voltage (which may be obtained via a same or different reference voltage nodes), the first transistor 201 and the third transistor are able to share the load, thereby allowing the third transistor to be smaller than it would need to be if it handled the pull functionality by itself. By allowing for a smaller third transistor to be used, chip space savings can be made. The operational amplifier 101 may be configured to enter the pull mode by setting the voltage at the control terminal of the first transistor 201 to an appropriate value such as, by way of example only, 5 V, as shown in figure 3B.

Figure 3C shows an example of the output stage 200 of the operational amplifier 101 when operating in a disconnected mode. In the disconnected mode, the output node is disconnected from both the operational amplifier 101 (or, at least, the rest of the operational amplifier) and the reference voltage node 205 via the first transistor 201. Thus, the operational amplifier 101 does not actively contribute to the voltage at the output node 104. It may be that the output node is coupled to a reference voltage node 205 via a different route, but in the disconnected mode of the operational amplifier 101, no path to the reference voltage is provided by the first transistor 201. The operational amplifier 101 may be configured to operate in the disconnected mode when the current source 102 is operating in the safe shutdown mode.

Thus, as shown across figures 3A - 3C, the operational amplifier 101 may be configured to switchably operate in any of a regulation mode, a pull mode and a disconnected mode.

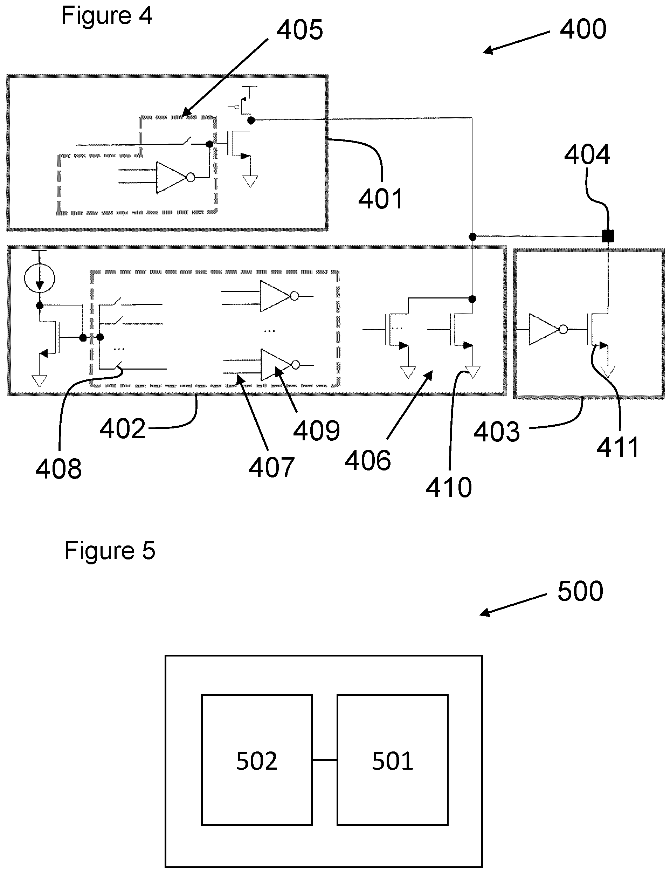

Figure 4 shows an example voltage gate driver 400 comprising an operational amplifier (only the output stage 401 is shown in figure 4), a programmable current source 402, a pull switch 403 and an output node 404. The output stage 401 of the operational amplifier depicted of figure 4 comprises a switching network 405, as described with reference to figures 2 - 3C.

The output stage of the programmable current switch 402 may comprise one output transistor or it may comprise a plurality of output transistors 406, which may be referred to as second transistors 406. The or each second transistor 406 comprises a control terminal which controls the how the second transistor or plurality of second transistors 406 impact the voltage at the output node 404. The or each second transistor 406 may comprise a respective second switching network 407. The second switching network 407 may be configured to control a mode of operation of the programmable current source. In embodiments comprising a plurality of second transistors 406, each second transistor 406 may be independently controllable by its respective switching network 407 such that the voltage provided at the output node 404 can be controlled.

The or each control terminal (gate or base) of the or each second transistor 406 of the output stage of the programmable current source 402 is coupled to the remainder of the programmable current source via its respective second switching network 407. The or each second switching network 407 is able to switchably control a mode of operation of its respective second output transistor 406 such that the programmable current source overall is controllable by voltages provided to the control terminal of the or each second transistor 406. Each second switching network comprises a programmable current source switch 408 coupled between the remainder of the programmable current source and its respective second transistor 406. The or each first programmable current source switch 408 may be configured to selectively couple its respective second transistor 406 to the rest of the programmable current source such that the programmable current source is configured to operate in the controlled shutdown mode when the first programmable current source switch 408 is closed to couple the second transistor 406 to the rest of the programmable current source. Each switching network 408 further comprises a second tri-state driver 409, which comprises a second current source (PCS) switch and a third current source (PCS) switch which provide for further control of the modes of operation of the programmable current source, analogously to the mode control described with reference to the operational amplifier and figures 3A - 3C.

When operating in the controlled shutdown mode, the or each first current source switch 408 may be closed such that a current source voltage V_CS is provided at the control terminal of the corresponding second transistor 406 such that the coupled power switch is caused to undergo a controlled shutdown. While operating in the controlled shutdown mode, the second and third current source switches of the second tri-state driver 409 are turned off (open) such that they do not contribute a voltage to the control terminal of the second transistor. In embodiments comprising a plurality of second transistors 406 and associated second switching networks 407, the switching networks may sequentially couple or decouple their respective second transistors to the rest of the current source in order to provide for the controlled shutdown by steadily altering the driving voltage at the output node 404.

When the programmable current source 402 is operating in the pull mode, the output node 404 of the voltage gate driver 400 may be coupled to the reference voltage node 410 via the second transistor 406 such that the output node 404 is set to the reference voltage, when in use. The programmable current source 402 may be configured to operate in the pull mode when the pull switch 403 is operating in the pull mode of the pull switch 403. By allowing both the programmable current source 402 and the pull switch 403 to simultaneously operate in a pull mode using the same reference voltage (which may be obtained via a same or different reference volage nodes), the second transistor 406 and the third transistor 411 are able to share the load, thereby allowing the third transistor 411 to be smaller than it would need to be if it handled the pull functionality by itself. By allowing for a smaller third transistor 411 to be used, chip space savings can be made. The programmable current source 402 may be configured to enter the pull mode by setting the voltage at the control terminal of the second transistor 406 to an appropriate value such as, by way of example only, 5 V.

In the disconnected mode of the programmable current source 402, the output node 404 is disconnected from both the programmable current source 402 (or at least, all of the programmable current source other than the second transistor 406) and the reference voltage node 410 via the second transistor 406. Thus, the programmable current source 402 does not actively contribute to the voltage at the output node 404. It may be that the output node 404 is coupled to a reference voltage node via a different route, but in the disconnected mode of the programmable current source 402, no path to the reference voltage is provided by the second transistor 406. The programmable current source 402 may be configured to operate in the disconnected mode when the operational amplifier 401 is operating in the regulation mode.

It will be appreciated that, as described above, the programmable current source 402 may have a plurality of second transistors 406 and associated switching networks 407. Any above descriptions referring to only a single transistor and single switching network is provided only for ease of reading but it will be appreciated that the discussions relate equally to a programmable current source 402 comprising a plurality of second transistors 406 and corresponding switching networks 407.

The voltage gate driver 400 of figure 4 depicts an embodiment comprising both an operational amplifier 401 comprising a first switching network 405 and a programmable current source 402 comprising a plurality of second switching networks 407. In other embodiments, a voltage gate driver 400 according to the present disclosure may only comprise a switching network 405, 407 in one of the operational amplifier 401 or the programmable current source 402. In embodiments in which the operational amplifier 401 does not comprise a switching network 405 for controlling operation in one of the three described modes, the operational amplifier 401 may be configured to switchably operate in either the regulation mode of the disconnected mode. Similarly, in embodiments in which the programmable current source 402 does not comprise one or more switching networks 407 for controlling operation in one of the three described modes, the programmable current source 402 may be configured to switchably operate in either the controlled shutdown mode or the disconnected mode.

The voltage gate driver may further comprise a mode controller (not shown) which is configured to control the mode of operation of the operational amplifier 401, the programmable current source 402 and the pull switch 403. The mode controller may be implemented in any suitable manner which allows for appropriate control signals to be applied to the first, second and third transistors and/or one or both of the first and/or second switching networks 405, 407.

Since the regulation mode of the operational amplifier 401, the controlled shutdown mode of the programmable current source 402 and the pull mode of all of the blocks 401, 402, 403 are configured provide for different modes of operation of the power switch by controlling the voltage at the output node 404 of the voltage gate driver 400, only a single one of these modes may be activate at any particular time. In particular, when the operational amplifier 401 is operating in the regulation mode, the programmable current source 402 and the pull switch 403 may be configured to operate in the disconnected modes. Similarly, when the programmable current source 402 is operating in the controlled shutdown mode, the operational amplifier 401 and the pull switch 403 may be configured to operate in the disconnected mode. Finally, when the pull switch 403 is operating in the pull mode, one or both of the operational amplifier 401 and the programmable current source 402 may be configured to operate in their respective pull modes.

Figure 5 shows an example power device 500 comprising a power switch 501 and a voltage gate driver 502 of the present disclosure wherein the voltage gate driver 502 is configured to drive the power switch 501. That is, the voltage gate driver 502 is configured to drive the gate voltage of the power switch 501. The power device 500 may be any suitable device in which it is desirable to implement a power switch 501 which is driven by a voltage gate driver 502. The power device may be, for example, a electric vehicle, an electric vehicle power train, an industrial motor driver or an energy storage system.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A voltage gate driver configured to provide a voltage at an output node for receipt by a gate of a power switch, the voltage gate driver comprising:
an operational amplifier comprising a first transistor;
a current source comprising a second transistor;
a pull switch comprising a third transistor wherein the pull switch is configured to switchably operate in one of:
a disconnected mode in which the output node is disconnected from a reference voltage node; and
a pull mode configured to couple the output node to the reference voltage node via the third transistor such that the voltage at the output
node is set to the reference voltage,
wherein one or both of:
a) the operational amplifier comprises a first switching network configured to control a mode of operation of the operational amplifier, wherein the operational amplifier is configured to switchably operate in one of:
a regulation mode configured to cause the first transistor to provide an intermediate voltage at the output node for driving the gate of the power switch;
a pull mode configured to couple the output node to the reference voltage node via the first transistor such that the voltage at the output node is set to the reference voltage and wherein the operational amplifier operates in the pull mode when the pull switch operates in the pull mode;
a disconnected mode in which the output node is disconnected from the operational amplifier and the reference voltage node; and
b) the current source comprises a second switching network configured to control a mode of operation of the current source, wherein the current source is configured to switchably operate in one of:
a controlled shutdown mode in which the second transistor provides a voltage at the output node for controlled shutdown of the power switch;
a pull mode configured to couple the output node to the reference voltage node via the second transistor such that the voltage at the output node is set to the reference voltage and wherein the current source operates in the pull mode when the pull switch operates in the pull mode;
a disconnected mode in which the output node is disconnected from the current source and the reference voltage node.

2. The voltage gate driver of claim 1 wherein the first switching network comprises:
a first OpAmp switch configured to selectively couple the first transistor to the rest of the operational amplifier such that, the operational amplifier is configured to operate in the regulation mode when the first transistor is coupled to the rest of the operational amplifier;
a second OpAmp switch and a third OpAmp switch of a first tri-state driver wherein the second and third OpAmp switches are configured to provide a first control voltage to a first control terminal of the first transistor when the first transistor is disconnected from the rest of the operational amplifier in order to cause the operational amplifier to selectively operate in one of the pull mode and the disconnected mode.

3. The voltage gate driver of claim 1 wherein the second switching network comprises:
a first PCS switch configured to selectively couple the second transistor to the rest of the current source such that, the current source is configured to operate in the controlled shutdown mode when the second transistor is coupled to the rest of the current source;
a second PCS switch and a third PCS switch of a second tri-state driver wherein the second and third PCS switches are configured to provide a second control voltage to a second control terminal of the second transistor when the second transistor is disconnected from the rest of the current source in order to cause the current source to selectively operate in one of the pull mode and the disconnected mode.

4. The voltage gate driver of any preceding claim further comprising a mode controller configured to control the mode of the operational amplifier, the current source and the pull switch.

5. The voltage gate driver of any preceding claim wherein only one of the regulation mode, the controlled shutdown mode and the pull mode is active at any time.

6. The voltage gate driver of claim 5 wherein:
when the operational amplifier is operating in the regulation mode, the current source and the pull switch are configured to operate in the disconnected mode;
when the current source is operating in the controlled shutdown mode, the operational amplifier and the pull switch are configured to operate in the disconnected mode; and
when the pull switch is operating in the pull mode, one or both of the operational amplifier and the current source are configured to operate in their respective pull modes.

7. The voltage gate driver of any preceding claim wherein the current source is a programmable current source.

8. A power device comprising a power switch and a voltage gate driver of any preceding claim configured to drive the power switch.
